(19) Europäisches Patentamt
European Patent Office
Office européen des brevets

(11) **EP 3 850 691 B1**

(12) **EUROPEAN PATENT SPECIFICATION**

(45) Date of publication and mention
of the grant of the patent:
**12.10.2022 Bulletin 2022/41**

(21) Application number: **19765200.1**

(22) Date of filing: **30.08.2019**

(51) International Patent Classification (IPC):
*H01M 4/1391* (2010.01)       *H01M 4/36* (2006.01)
*C23C 16/44* (2006.01)       *C23C 16/455* (2006.01)
*H01M 4/505* (2010.01)       *H01M 4/525* (2010.01)

(52) Cooperative Patent Classification (CPC):
**H01M 4/366; C23C 16/403; C23C 16/4417;
C23C 16/442; C23C 16/45527; C23C 16/45553;
C23C 16/45555; H01M 4/1391; H01M 4/505;
H01M 4/525;** Y02E 60/10

(86) International application number:
**PCT/EP2019/073197**

(87) International publication number:
**WO 2020/052995 (19.03.2020 Gazette 2020/12)**

(54) **PROCESS FOR COATING AN OXIDE MATERIAL**

VERFAHREN ZUR BESCHICHTUNG EINES OXIDMATERIALS

PROCÉDÉ DE REVÊTEMENT D'UN MATÉRIAU D'OXYDE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **11.09.2018 EP 18193632**

(43) Date of publication of application:
**21.07.2021 Bulletin 2021/29**

(73) Proprietor: **BASF SE**
**67056 Ludwigshafen am Rhein (DE)**

(72) Inventors:
• **AHLF, Maraike**
**67056 Ludwigshafen (DE)**
• **SOMMER, Heino**
**67056 Ludwigshafen (DE)**
• **SUELING, Carsten**
**67056 Ludwigshafen (DE)**
• **GRONER, Markus**
**Louisville, Colorado 80027 (US)**
• **GUMP, Christopher**
**Louisville, Colorado 80027 (US)**
• **HALL, Robert**
**Denver, Colorado 80205-2917 (US)**
• **SPENCER II, Joseph**
**Longmont, Colorado 80503 (US)**

(74) Representative: **BASF IP Association**
**BASF SE**
**GBI-C006**
**67056 Ludwigshafen (DE)**

(56) References cited:
**WO-A1-2007/122418       WO-A1-2018/019627
WO-A1-2018/162234       KR-A- 20140 006 420
US-A1- 2016 260 962       US-A1- 2017 207 455
US-B2- 8 993 051**

• **DAVID H. K. JACKSON ET AL: "Optimizing AIF 3
atomic layer deposition using trimethylaluminum
and TaF 5 : Application to high voltage Li-ion
battery cathodes", JOURNAL OF VACUUM
SCIENCE AND TECHNOLOGY: PART A., vol. 34,
no. 3, 1 May 2016 (2016-05-01), page 031503,
XP055554565, MELVILLE, NY., US ISSN:
0734-2101, DOI: 10.1116/1.4943385**
• **H. VAN BUI ET AL: "Atomic and molecular layer
deposition: off the beaten track", CHEMICAL
COMMUNICATIONS, vol. 53, no. 1, 1 January 2017
(2017-01-01), pages 45-71, XP055552792, ISSN:
1359-7345, DOI: 10.1039/C6CC05568K**

- **LONGRIE DELPHINE ET AL: "Reactor concepts for atomic layer deposition on agitated particles: A review", JOURNAL OF VACUUM SCIENCE AND TECHNOLOGY: PART A, AVS /AIP, MELVILLE, NY., US, vol. 32, no. 1, 1 January 1901 (1901-01-01), XP012184400, ISSN: 0734-2101, DOI: 10.1116/1.4851676 [retrieved on 1901-01-01]**

**Description**

The present invention is related to a process for coating an oxide material, said process comprising the following steps:

(a) providing a particulate material selected from lithiated nickel-cobalt aluminum oxides, lithiated cobalt-manganese oxides and lithiated layered nickel-cobalt-manganese oxides,
(b) treating said cathode active material with a metal alkoxide or metal amide or alkyl metal compound at a pressure that is in the range of from 5 mbar to 1 bar above ambient pressure,
(c) deactivating the material obtained in step (b) with an HF containing gas at ambient pressure,

wherein steps (b) and (c) are carried out in a mixer that mechanically introduces mixing energy into the particulate material, or by way of a moving bed or fixed bed wherein an inert gas containing a metal alkoxide or metal amide or alkyl metal compound flows from top to bottom through the respective bed.

Lithium ion secondary batteries are modern devices for storing energy. Many application fields have been and are contemplated, from small devices such as mobile phones and laptop computers through car batteries and other batteries for e-mobility. Various components of the batteries have a decisive role with respect to the performance of the battery such as the electrolyte, the electrode materials, and the separator. Particular attention has been paid to the cathode materials. Several materials have been suggested, such as lithium iron phosphates, lithium cobalt oxides, and lithium nickel cobalt manganese oxides. Although extensive research has been performed the solutions found so far still leave room for improvement.

One problem of lithium ion batteries lies in undesired reactions on the surface of the cathode active materials. Such reactions may be a decomposition of the electrolyte or the solvent or both. It has thus been tried to protect the surface without hindering the lithium ion exchange during charging and discharging. Examples are attempts to coat the surface of the cathode active materials with, e.g., aluminium oxide or calcium oxide, see, e.g., US 8,993,051. Other coating processes are described in publications WO2018019627 and US2016260962.

The efficiency of the process, however, may still be improved. Especially in embodiments wherein the particles have a tendency to agglomerate the efficiency sometimes leaves room for improvement both in respect to reaction time and percentage of covered particles as well as percentage of coverage of particles.

It was therefore an objective of the present invention to provide a process by which particulate materials may be coated without an unduly long reaction time wherein such particulate materials have a tendency to form agglomerates. It was further an objective to provide a reactor for performing such a process.

Accordingly, the process as defined at the outset has been found, hereinafter also referred to as inventive process or as process according to the (present) invention. The inventive process is a process for coating a particulate material.

Coated materials as obtained in the context with the present invention refer to at least 80% of the particles of a batch of particulate material being coated, and to at least 75% of the surface of each particle being coated, for example 75 to 99.99 % and preferably 80 to 90%.

The thickness of such coating may be very low, for example 0.1 to 5 nm. In other embodiments, the thickness may be in the range of from 6 to 15 nm. In further embodiments, the thickness of such coating is in the range of from 16 to 50 nm. The thickness in this context refers to an average thickness determined mathematically by calculating the amount of metal alkoxide or metal amide or alkyl metal compound per particle surface in $m^2$ and assuming a 100% conversion in steps (b) and (c).

Without wishing to be bound by any theory, it is believed that non-coated parts of particles do not react due to specific chemical properties of the particles, for example density of chemically reactive groups such as, but not limited to hydroxyl groups, oxide moieties with chemical constraint, or to adsorbed water.

In one embodiment of the present invention the particulate material has an average particle diameter (D50) in the range of from 3 to 20 $\mu$m, preferably from 5 to 16 $\mu$m. The average particle diameter can be determined, e. g., by light scattering or LASER diffraction. The particles are usually composed of agglomerates from primary particles, and the above particle diameter refers to the secondary particle diameter.

In one embodiment of the present invention, the particulate material has a specific surface, hereinafter also "BET surface", in the range of from 0.1 to 1.5 $m^2$/g. The BET surface may be determined by nitrogen adsorption after outgassing of the sample at 200°C for 30 minutes or more and beyond this accordance with DIN ISO 9277:2010.

The inventive process comprises three steps (a), (b) and (c), in the context of the present invention also referred to as step (a), step (b) and step (c).

Step (a) includes providing a particulate material selected from lithiated nickel-cobalt aluminum oxides, and lithiated cobalt-manganese oxide. Examples of lithiated layered cobalt-manganese oxides are $Li_{1+x}(Co_eMn_fM^4_d)_{1-x}O_2$. Examples of layered nickel-cobalt-manganese oxides are compounds of the general formula $Li_{1+x}(Ni_aCo_bMn_cM^4_d)_{1-x}O_2$,

with $M^4$ being selected from Mg, Ca, Ba, Al, Ti, Zr, Zn, Mo, Nb, V and Fe, the further variables being defined as follows:

zero $\leq x \leq 0.2$

$0.1 \leq a \leq 0.95$,

zero $\leq b \leq 0.5$,

$0.1 \leq c \leq 0.6$,

zero $\leq d \leq 0.1$, and $a + b + c + d = 1$.

In a preferred embodiment, in compounds according to general formula (I)

$$Li_{(1+x)}[Ni_aCo_bMn_cM^4{}_d]_{(1-x)}O_2 \qquad (I)$$

$M^4$ is selected from Ca, Mg, Al and Ba,

and the further variables are defined as above.

In $Li_{1+x}(Co_eMn_fM^4{}_d)_{1-x}O_2$, e is in the range of from 0.2 to 0.99, f is in the range of from 0.01 to 0.8, the variables $M^4$ and d and x are as defined above, and $e + f + d = 1$.

Examples of lithiated nickel-cobalt aluminum oxides are compounds of the general formula $Li[Ni_hCo_iAl_j]O_{2+r}$. Typical values for r, h, i and j are:

h is in the range of from 0.8 to 0.95,
i is in the range of from 0.015 to 0.19,
j is in the range of from 0.01 to 0.08, and
r is in the range of from zero to 0.4.

Particularly preferred are $Li_{(1+x)}[Ni_{0.33}Co_{0.33}Mn_{0.33}]_{(1-x)}O_2$, $Li_{(1+x)}[Ni_{0.5}Co_{0.2}Mn_{0.3}]_{(1-x)}O_2$, $Li_{(1+x)}[Ni_{0.6}Co_{0.2}Mn_{0.2}]_{(1-x)}O_2$, $Li_{(1+x)}[Ni_{0.7}Co_{0.2}Mn_{0.1}]_{(1-x)}O_2$, and $Li_{(1+x)}[Ni_{0.8}Co_{0.1}Mn_{0.1}]_{(1-x)}O_2$, each with x as defined above, and $Li[Ni_{0.88}Co_{0.065}Al_{0.055}]O_2$ and $Li[Ni_{0.91}Co_{0.045}Al_{0.045}]O_2$.

Said particulate material is preferably provided without any additive such as conductive carbon or binder but as free-flowing powder.

In one embodiment of the present invention particles of particulate material such as lithiated nickel-cobalt aluminum oxide or layered lithium transition metal oxide, respectively, are cohesive. That means that according to the Geldart grouping, the particulate material is difficult to fluidize and therefore qualifies for the Geldart C region. In the course of the present invention, though, mechanical stirring is not required in all embodiments.

Further examples of cohesive products are those with a flowability factor $ff_c \leq 7$, preferably $1 < ff_c \leq 7$ ($ff_c = \sigma_1 / \sigma_c$; $\sigma_1$ - major principle stress, $\sigma_c$ - unconfined yield strength) according to Jenike or those with a Hausner ratio $f_H \geq 1.1$, preferably $1.6 \geq f_H \geq 1.1$ ($f_H = \rho_{tap} / \rho_{bulk}$; $\rho_{tap}$ - tapped density measured after 1250 strokes in jolting volumeter, $\rho_{bulk}$ - bulk density according to DIN EN ISO 60).

In step (b) of the inventive process, the particulate material provided in step (a) is treated with a metal alkoxide or metal amide or alkyl metal compound. The treatment will be described in more detail below.

Steps (b) and (c) of the inventive process are performed in a vessel or a cascade of at least two vessels, said vessel or cascade - if applicable - also being referred to as reactor in the context of the present invention. Preferably, steps (b) and (c) are performed in the same vessel.

In one embodiment of the inventive process, step (b) is performed at a temperature in the range of from 15 to 1000°C, preferably 15 to 500°C, more preferably 20 to 350°C, and even more preferably 150 to 200°C. It is preferred to select a temperature in step (b) at which metal alkoxide or metal amide or alkyl metal compound, as the case may be, is in the gas phase.

Step (b) is carried out at a pressure above ambient pressure. Thus, step (b) is carried out at a pressure in the range of from 5 mbar to 1 bar above ambient pressure, preferably 10 to 150 mbar above ambient pressure and more preferably 10 to 560 mbar above ambient pressure. In the context of the present invention, ambient pressure refers to ambient pressure. At sea level, ambient pressure is $10^5$ Pa, but depending on the altitude of the place where the inventive process is performed, ambient pressure may be lower. In a particularly preferred embodiment, in step (b) the pressure is in the range of from 5 to 350 mbar above ambient pressure.

In a preferred embodiment of the present invention, alkyl metal compound or metal alkoxide or metal amide, respectively, is selected from $M^1(R^1)_2$, $M^2(R^1)_3$, $M^3(R^1)_{4-y}H_y$, $M^1(OR^2)_2$, $M^2(OR^2)_3$, $M^3(OR^2)_4$, $M^3[N(R^2)_2]_4$, and compounds of $M^1$ or $M^2$ or $M^3$ with combinations of counterions, for example $M^1(R^1)X$, $M^2(R^1)_2X$, $M^2R^1X_2$, $M^3(R^1)_3X$, $M^3(R^1)_2X_2$, $M^3R^1X_3$, and compounds with two metal atoms per molecule such as, but not limited to, methyl alumoxane, wherein

$R^1$ are different or equal and selected from hydride and $C_1$-$C_8$-alkyl, straight-chain or branched,

$R^2$ are different or equal and selected from $C_1$-$C_4$-alkyl, straight-chain or branched,

$M^1$ is selected from Mg and Zn,

$M^2$ is selected from Al and B,

$M^3$ is selected from Si, Sn, Ti, Zr, and Hf, with Sn and Ti being preferred,

X is selected from halide, same or different with fluoride being preferred and chloride being more preferred,

the variable y is selected from zero to 4, especially zero and 1.

Metal alkoxides may be selected from $C_1$-$C_4$-alkoxides of alkali metals, preferably sodium and potassium, alkali earth metals, preferably magnesium and calcium, aluminum, silicon, and transition metals. Preferred transition metals are titanium and zirconium. Examples of alkoxides are methanolates, hereinafter also referred to as methoxides, ethanolates, hereinafter also referred to as ethoxides, propanolates, hereinafter also referred to as propoxides, and butanolates, hereinafter also referred to as butoxides. Specific examples of propoxides are n-propoxides and isopropoxides. Specific examples of butoxides are n-butoxides, iso-butoxides, sec.-butoxides and tert.-butoxides. Combinations of alkoxides are feasible as well.

Examples of alkali metal alkoxides are $NaOCH_3$, $NaOC_2H_5$, NaO-iso-$C_3H_7$, $KOCH_3$, KO-iso-$C_3H_7$, and K-O-$C(CH_3)_3$.

Preferred examples of metal $C_1$-$C_4$-alkoxides are $Si(OCH_3)_4$, $Si(OC_2H_5)_4$, Si(O-n-$C_3H_7)_4$, Si(O-iso-$C_3H_7)_4$, Si(O-n-$C_4H_9)_4$, $Ti[OCH(CH_3)_2]_4$, $Ti(OC_4H_9)_4$, $Zn(OC_3H_7)_2$, $Zr(OC_4H_9)_4$, $Zr(OC_2H_5)_4$, $Al(OCH_3)_3$, $Al(OC_2H_5)_3$, Al(O-n-$C_3H_7)_3$, Al(O-iso-$C_3H_7)_3$, Al(O-sec.-$C_4H_9)_3$, and $Al(OC_2H_5)$(O-sec.-$C_4H_9)_2$.

Examples of metal alkyl compounds of an alkali metal selected from lithium, sodium and potassium, with alkyl lithium compounds such as methyl lithium, n-butyl lithium and n-hexyl lithium being particularly preferred. Examples of alkyl compounds of alkali earth metals are di-n-butyl magnesium and n-butyl-n-octyl magnesium ("BOMAG"). Examples of alkyl zinc compounds are dimethyl zinc and zinc diethyl.

Examples of aluminum alkyl compounds are trimethyl aluminum, triethyl aluminum, triisobutyl aluminum, and methyl alumoxane.

Metal amides are sometimes also referred to as metal imides. Examples of metal amides are $Na[N(CH_3)_2]$, $Li[N(CH_3)_2]$, $Si[N(CH_3)_2]_4$ and $Ti[N(CH_3)_2]_4$.

Examples of compounds of $M^1$ or $M^2$ or $M^3$ with combinations of counterions are $AlCl(CH_3)_2$, $AlCl_2CH_3$, $(CH_3)_3SiCl$, $CH_3SiCl_3$, and $H_wSi[N(CH_3)_2]_{4-w}$ with w being a number from 1 to 4.

Particularly preferred compounds are selected from metal $C_1$-$C_4$-alkoxides and metal $C_1$-$C_4$-alkyl compounds, and even more preferred is trimethyl aluminum.

In one embodiment of the present invention, the amount of metal alkoxide or metal amide or alkyl metal compound or metal halide is in the range of 0.1 to 1 g/kg particulate material.

Preferably, the amount of metal alkoxide or metal amide or alkyl metal compound or metal halide, respectively, is calculated to amount to 80 to 200% of a monomolecular layer on the particulate material.

In a preferred embodiment of the present invention, the duration of step (b) is in the range of from 1 second to 2 hours, preferably 1 second up to 10 minutes.

In a third step, in the context of the present invention also referred to as step (c), the material obtained in step (b) is deactivated with a gas containing HF at ambient pressure In one embodiment of the present invention, step (c) is carried out at a temperature in the range of from 50 to 250°C.

HF may be introduced into step (c) directly or by heating a material that releases HF upon heating, for example ammonium salts of HF, for example $NH_4F$ or $NH_4F \cdot HF$ or HF·pyridine.

In one embodiment of the present invention, in step (b) cathode active material is treated with a metal alkoxide or metal amide or alkyl metal compound at a pressure that is in the range of from 5 mbar to 1 bar above ambient pressure, and in step (c), the material obtained from step (b) is deactivated with an HF containing gas at ambient pressure.

In the context of the present invention, ambient pressure is defined as in the context of step (b).

Said HF may be introduced, e.g., by treating the material obtained in accordance with step (b) with HF saturated inert gas, for example with nitrogen saturated with HF or a noble gas saturated with HF, for example argon. Saturation may refer to normal conditions or to the reaction conditions in step (c).

On one embodiment of the present invention, step (c) has a duration in the range of from 10 seconds to 2 hours, preferable 1 second to 10 minutes.

The sequence of steps (b) and (c) is carried out only once.

In a preferred embodiment of the present invention, step (c) is carried out in an atmosphere that is free from carbon dioxide. In the context of the present invention, "free from carbon dioxide" means that the respective atmosphere has a carbon dioxide content in the range of from 0.01 to 500 ppm by weight or even less, preferred are 0.1 to 50 ppm by weight or even less. The $CO_2$ content may be determined by, e.g., optical methods using infrared light. It is even more preferred to use an atmosphere with a carbon dioxide below detection limit for example with infrared-light based optical methods.

Steps (b) and (c) of the inventive process may be carried out continuously or batch-wise.

In one embodiment of the present invention, the reactor in which the inventive process is carried out is flushed or purged with an inert gas between steps (b) and (c), for example with dry nitrogen or with dry argon. Suitable flushing - or purging - times are 1 second to 30 minutes, preferably 1 minute to 10 minutes. It is preferred that the amount of inert gas is sufficient to exchange the contents of the reactor of from one to 15 times. By such flushing or purging, the production of by-products such as separate particles of reaction product of metal alkoxide or metal amide or alkyl metal compound, respectively, with water can be avoided. In the case of the couple trimethyl aluminum and water, such by-products are methane and alumina or trimethyl aluminum that is not deposited on the particulate material, the latter being an undesired by-product.

Various embodiments of reactor design are possible to perform the steps (b) and (c) of the inventive process. Steps (b) and (c) are carried out in a mixer that mechanically introduces mixing energy into the particulate material, for example compulsory mixers and free-fall mixers. While free fall mixers utilize the gravitational forces for moving the particles compulsory mixers work with moving, in particular rotating mixing elements that are installed in the mixing room. In the context of the present invention, the mixing room is the reactor interior. Examples of compulsory mixers are ploughshare mixers, in German also called Lödige mixers, paddle mixers and shovel mixers. Preferred are plough-share mixers. Ploughshare mixers may be installed vertically or horizontally, the term horizontal or vertical, respectively, referring to the axis around which the mixing element rotates. Horizontal installation is preferred. Preferably, the inventive process is carried out in a ploughshare mixer in accordance with the hurling and whirling principle.

In another embodiment of the present invention, the inventive process may be carried out in a free fall mixer. Free fall mixers are using the gravitational force to achieve mixing. In a preferred embodiment, steps (b) and (c) of the inventive process are carried out in a drum or pipe-shaped vessel that rotates around its horizontal axis. In a more preferred embodiment, steps (b) and (c) of the inventive process are carried out in a rotating vessel that has baffles.

In one embodiment of the present invention a vessel or at least parts of it rotates with a speed in the range of from 5 to 500 revolutions per minute ("rpm"), preferred are 5 to 60 rpm. In embodiments wherein a free-fall mixer is applied, from 5 to 25 rpm are more preferred and 5 to 10 rpm are even more preferred. In embodiments wherein a plough-share mixer is applied, 50 to 400 rpm are preferred and 100 to 250 rpm are even more preferred.

In another embodiment of the present invention, steps (b) and (c) are carried out by way of a moving bed or fixed bed. In a fixed bed process, the particulate material provided in step (a) is placed upon a porous area, for example a sieve plate. Hereby, particulate material provided in step (a) forms a bed. In step (b) a medium, especially an inert gas containing a metal alkoxide or metal amide or alkyl metal compound flows from top to bottom through the bed, and in step (c), moisture, e.g., in the form of humid nitrogen or humid air, from bottom to top or from top to bottom through the bed.

In a moving bed process, particulate material provided in step (a) are introduced at the top of a tubular reactor, thereby automatically forming a particle bed. A gas stream containing a metal alkoxide or metal amide or alkyl metal compound flows bottom-up through said bed with a gas velocity that is not sufficient to keep the particle bed in a steady state. Instead, the particle bed moves counter-currently with the gas stream (step (b). Step (c) is carried out accordingly but with moisture or HF instead of metal alkoxide or metal amide or alkyl metal.

In a preferred version of the present invention, which allows for the pneumatic conveying of said particulate material, a pressure difference up to 4 bar is applied. Coated particles may be blown out of the reactor or removed by suction.

In one embodiment of the present invention, the inlet pressure is higher but close to the desired reactor pressure. Pressure drops of gas inlet and in the moving or fixed bed, if applicable, have to be compensated.

In the course of the inventive process strong shear forces are introduced into the fluidized bed due to the shape of the reactor, the particles in the agglomerates are exchanged frequently, which allows for the accessibility of the full particle surface. By the inventive process, particulate materials may be coated in short time, and in particular cohesive particles may be coated very evenly.

In a preferred embodiment of the present invention the inventive process comprises the step of removing the coated material from the reactor in which steps (b) and (c) are carried out by pneumatic convection, e.g. 20 to 100 m/s.

In one embodiment of the present invention, the exhaust gasses are treated with water at a pressure above ambient pressure and even more preferably slightly lower than in the reactor in which steps (b) and (c) are performed, for example in the range of from 2 mbar to 1 bar more than ambient pressure, preferably in the range of from 4 mbar to 25 mbar above ambient pressure. The elevated pressure is advantageous to compensate for the pressure loss in the exhaust lines.

The sealings necessary for separating the reactor and the exhaust gas treatment vessel from the environment are advantageously equipped with nitrogen flushing.

In one embodiment of the present invention, the gas inlet and the outlet are at opposite positions of the vessel used for the inventive process.

In one embodiment of the present invention, the coated oxide material obtained after step (c) is subjected to an after-treatment step (d), for example a thermal after-treatment at a temperature in the range of from 100 to 500°C at a pressure in the range of from 1 mbar to $10^5$ Pa over a period in the range of from 5 minutes to 5 hours.

By the inventive process, particulate materials may be coated in short time, and in particular cohesive particles may be coated very evenly. The inventive process allows for good safety because any combustible or even explosive atmosphere may be easily avoided.

The progress of the inventive process may be controlled by mass spectrometry.

The inventive process is illustrated by the following working example. Ambient pressure $10^5$ Pa. sccm: standard cubic centimeter per minute

I. Cathode active materials

1.1. Preparation of a precursor for cathode active materials

A stirred tank reactor was filled with deionized water. The precipitation of mixed transition metal hydroxide precursor was started by simultaneous feed of an aqueous transition metal solution and an alkaline precipitation agent at a flow rate ratio of 1.9, and a total flow rate resulting in a residence time of 8 hours. The aqueous transition metal solution contained Ni, Co and Mn at a molar ratio of 6:2:2 as sulfates each and a total transition metal concentration of 1.65 mol/kg. The alkaline precipitation agent consisted of 25 wt.% sodium hydroxide solution and 25 wt.% ammonia solution in a weight ratio of 25. The pH value was kept at 11.9 by separate feed of an aqueous sodium hydroxide solution. After stabilization of particle size the resulting suspension was removed continuously from the stirred vessel. The mixed transition metal (TM) oxyhydroxide precursor was obtained by filtration of the resulting suspension, washing with distilled water, drying at 120 °C in air and sieving.

1.2. Manufacture of cathode active materials

C-CAM.1 (Comparative): The mixed transition metal oxyhydroxide precursor obtained according to 1.1 was mixed with $Al_2O_3$ (average particle diameter 6 nm) and LiOH monohydrate to obtain a concentration of 0.3 mole-% Al relative to Ni+Co+Mn+Al and a Li/(TM+Al) molar ratio of 1.03. The mixture was heated to 885°C and kept for 8 hours in a forced flow of oxygen to obtain the electrode active material C-CAM 1.

D50 = 9.5 $\mu$m determined using the technique of laser diffraction in a Mastersize 3000 instrument from Malvern Instruments. Al-content was determined by ICP analytics and corresponded to 820 ppm. Residual moisture at 250 °C was determined to be 300 ppm.

CAM.2 (not according to the invention, but useful to understand the invention): A fluidized bed reactor with external heating jacket is charged with 100 g of C-CAM.1, and at an average pressure of 1030 mbar, C-CAM.1 is fluidized. The fluidized bed reactor is heated to 180 °C and kept at 180 °C for 3 h.

Step (b.1): Trimethylaluminum (TMA) in the gaseous state is introduced into the fluidized bed reactor through a filter plate by opening a valve to a precursor reservoir that contained TMA in liquid form and that is kept at 50° C. The TMA is diluted with nitrogen as carrier gas. The gas flow of TMA and $N_2$ is 10 sccm. After a reaction period of 210 seconds non-reacted TMA is removed through the nitrogen stream, and the reactor is purged with nitrogen for 15 minutes with a flow of 30 sccm.

Step (c.1): Then, the pressure is set to ambient pressure ($10^5$ Pa). Water in the gaseous state is introduced into the fluidized bed reactor by opening a valve to a reservoir that contained liquid water kept at 24 °C, flow: 10 sccm. After a reaction period of 120 seconds non-reacted water is removed through a nitrogen stream, and the reactor was purged with nitrogen, 15 minutes at 30 sccm. Coated oxide material CAM.2 is obtained.

**Claims**

**1.** Process for making a coated oxide material, said process comprising the following steps:

(a) providing a particulate material selected from lithiated nickel-cobalt aluminum oxides, lithiated cobalt-manganese oxides and lithiated layered nickel-cobalt-manganese oxides,

(b) treating said cathode active material with a metal alkoxide or metal amide or alkyl metal compound at a pressure that is in the range of from 5 mbar to 1 bar above ambient pressure,

(c) deactivating the material obtained in step (b) with an HF containing gas at ambient pressure,

wherein step (b) is carried out in a mixer that mechanically introduces mixing energy into the particulate material and that is selected from compulsory mixers and free-fall mixers, or by way of a moving bed or fixed bed wherein an inert gas containing a metal alkoxide or metal amide or alkyl metal compound flows from top to bottom through the respective bed.

2. Process according to claim 1 wherein step (c) is carried out in an atmosphere that is free from carbon dioxide.

3. Process according to claim 1 or 2 wherein alkyl metal compound or metal alkoxide or metal amide or metal halide or metal hydride, respectively, is selected from $M^1(R^1)_2$, $M^2(R^1)_3$, $M^3(R^1)_{4-y}H_y$, $M^1(OR^2)_2$, $M^2(OR^2)_3$, $M^3(OR^2)_4$, $M^3[N(R^2)_2]_4$, and methyl alumoxane, wherein

$R^1$ are different or equal and selected from hydride and $C_1$-$C_8$-alkyl, straight-chain or branched,
$R^2$ are different or equal and selected from $C_1$-$C_4$-alkyl, straight-chain or branched,
$M^1$ is selected from Mg and Zn,
$M^2$ is selected from Al and B,
$M^3$ is selected from Si, Sn, Ti, Zr, and Hf,
the variable y is selected from zero to 4.

4. Process according to any of the preceding claims wherein lithiated layered nickel-cobalt-manganese oxide is a material of general formula (I)

$$Li_{(1+x)}[Ni_aCo_bMn_cM^4_d]_{(1-x)}O_2 \qquad (I)$$

wherein

$M^4$ is selected from Mg, Ca, Ba, Al, Ti, Zr, Zn, Nb, Mo, V and Fe,
$zero \le x \le 0.2$
$0.1 \le a \le 0.8$,
$zero < b \le 0.5$,
$0.1 \le c \le 0.6$,
$zero \le d \le 0.1$,
and

$$a + b + c + d = 1.$$

5. Process according to any of the preceding claims wherein the exhaust gasses are treated with water at a pressure above ambient pressure.

6. Process according to claim 5 wherein the exhaust gasses are treated with water at a pressure in the range of from 5 mbar to 1 bar above ambient pressure.

7. Process according to any of the preceding claims wherein in step (b) the pressure is in the range of from 5 to 350 mbar above ambient pressure.

8. Process according to any of the preceding claims wherein particles of lithiated nickel-cobalt aluminum oxide or lithiated layered nickel-cobalt-manganese oxide, respectively, are cohesive.

9. Process according to any of the preceding claims wherein step (b) is performed at a temperature in the range of from 15 to 350°C.

10. Process according to any of the preceding claims wherein the reactor in which step (b) is carried out is flushed with an inert gas between steps (b) and (c).

**11.** Process according to any of the preceding steps comprising the step of removing the coated material from the reactor in which steps (b) and (c) are carried out by pneumatic convection.

**Patentansprüche**

**1.** Verfahren zur Herstellung eines beschichteten Oxidmaterials, wobei das Verfahren die folgenden Schritte umfasst:

(a) Bereitstellen eines teilchenförmigen Materials, ausgewählt aus lithiierten Nickelcobaltaluminiumoxiden, lithiierten Cobaltmanganoxiden und lithiierten schichtförmigen Nickelcobaltmanganoxiden,
(b) Behandeln des Kathodenaktivmaterials mit einer Metallalkoxid- oder Metallamid- oder Alkylmetall-Verbindung bei einem Druck, der im Bereich von 5 mbar bis 1 bar über Umgebungsdruck liegt,
(c) Desaktivieren des in Schritt (b) erhaltenen Materials mit einem HF enthaltenden Gas bei Umgebungsdruck,

wobei Schritt (b) in einem Mischer, der mechanisch Energie in das teilchenförmige Material einträgt und aus Zwangsmischern und Freifallmischern ausgewählt wird, oder mit einem Bewegtbett oder Festbett durchgeführt wird, wobei ein eine Metallalkoxid- oder Metallamid- oder Alkylmetallverbindung enthaltendes Inertgas von oben nach unten durch das jeweilige Bett strömt.

**2.** Verfahren nach Anspruch 1, wobei Schritt (c) in einer kohlendioxidfreien Atmosphäre durchgeführt wird.

**3.** Verfahren nach Anspruch 1 oder 2, wobei die Alkylmetallverbindung bzw. das Metallalkoxid bzw. das Metallamid bzw. das Metallhydrid aus $M^1(R^1)_2$, $M^2(R^1)_3$, $M^3(R^1)_{4-y}H_y$, $M^1(OR^2)_2$, $M^2(OR^2)_3$, $M^3(OR^2)_4$, $M^3[N(R^2)_2]_4$ und Methylalumoxan ausgewählt wird, wobei

die Reste $R^1$ gleich oder verschieden sind und aus Hydrid und geradkettigem oder verzweigtem $C_1$-$C_8$-Alkyl ausgewählt sind,
die Reste $R^2$ gleich oder verschieden sind und aus geradkettigem oder verzweigtem $C_1$-$C_4$-Alkyl ausgewählt sind,
$M^1$ aus Mg und Zn ausgewählt ist,
$M^2$ aus Al und B ausgewählt ist,
$M^3$ aus Si, Sn, Ti, Zr und Hf ausgewählt ist,
die Variable y aus null bis 4 ausgewählt ist.

**4.** Verfahren nach einem der vorhergehenden Ansprüche, wobei es sich bei dem lithiierten schichtförmigen Nickelcobaltmanganoxid um ein Material der allgemeinen Formel (I)

$$Li_{(1+x)}[Ni_aCo_bMn_cM^4_d]_{(1-x)}O_2 \qquad (I)$$

handelt, wobei

$M^4$ aus Mg, Ca, Ba, Al, Ti, Zr, Zn, Nb, Mo, V und Fe ausgewählt ist,
$null \leq x \leq 0,2$,
$0,1 \leq a \leq 0,8$,
$null < b \leq 0,5$,
$0,1 \leq c \leq 0,6$,
$null \leq d \leq 0,1$
und

$$a + b + c + d = 1.$$

**5.** Verfahren nach einem der vorhergehenden Ansprüche, wobei die Abgase bei einem Druck über Umgebungsdruck mit Wasser behandelt werden.

**6.** Verfahren nach Anspruch 5, wobei die Abgase bei einem Druck im Bereich von 5 mbar bis 1 bar über Umgebungsdruck mit Wasser behandelt werden.

7. Verfahren nach einem der vorhergehenden Ansprüche, wobei in Schritt (b) der Druck im Bereich von 5 bis 350 mbar über Umgebungsdruck liegt.

8. Verfahren nach einem der vorhergehenden Ansprüche, wobei Teilchen von lithiiertem Nickelcobaltmanganoxid bzw. lithiiertem schichtförmigem Nickelcobaltmanganoxid kohäsiv sind.

9. Verfahren nach einem der vorhergehenden Ansprüche, wobei Schritt (b) bei einer Temperatur im Bereich von 15 bis 350 °C durchgeführt wird.

10. Verfahren nach einem der vorhergehenden Ansprüche, wobei der Reaktor, in dem Schritt (b) durchgeführt wird, zwischen den Schritten (b) und (c) mit einem Inertgas gespült wird.

11. Verfahren nach einem der vorhergehenden Ansprüche, umfassend den Schritt des Entfernens des beschichteten Materials aus dem Reaktor, in dem die Schritte (b) und (c) durchgeführt werden, durch pneumatische Konvektion.

**Revendications**

1. Procédé pour la préparation d'un matériau d'oxyde revêtu, ledit procédé comprenant les étapes suivantes :

   (a) fourniture d'un matériau particulaire choisi parmi des oxydes de nickel-cobalt aluminium lithiés, des oxydes de cobalt-manganèse lithiés et des oxydes de nickel-cobalt-manganèse stratifiés lithiés,
   (b) traitement dudit matériau actif de cathode avec un alcoxyde métallique ou un composé de type amidure métallique ou alkyl-métal à une pression qui est dans la plage allant de 5 mbars à 1 bar au-dessus de la pression ambiante,
   (c) désactivation du matériau obtenu dans l'étape (b) avec un gaz contenant du HF à pression ambiante,

   l'étape (b) étant mise en œuvre dans un mélangeur qui introduit mécaniquement de l'énergie de mélange dans le matériau particulaire et qui est choisi parmi des mélangeurs à action forcée et des mélangeurs à chute libre, ou au moyen d'un lit mobile ou d'un lit fixe, un gaz inerte contenant un alcoxyde métallique ou un composé de type amidure métallique ou alkyl-métal s'écoulant de la partie supérieure vers la partie inférieure à travers le lit respectif.

2. Procédé selon la revendication 1, l'étape (c) étant mise en œuvre dans une atmosphère qui est exempte de dioxyde de carbone.

3. Procédé selon la revendication 1 ou 2, le composé de type alkyl-métal ou l'alcoxyde métallique ou l'amidure métallique ou l'halogénure métallique ou l'hydrure métallique, respectivement, étant choisi parmi $M^1(R^1)_2$, $M^2(R^1)_3$, $M^3(R^1)_{4-y}H_y$, $M^1(OR^2)_2$, $M^2(OR^2)_3$, $M^3(OR^2)_4$, $M^3[N(R^2)_2]_4$ et le méthylalumoxane,

   $R^1$ étant différents ou identiques et étant choisis parmi hydrure et $C_{1-8}$-alkyle, à chaîne droite ou ramifié,
   $R^2$ étant différents ou identiques et étant choisis parmi $C_{1-4}$-alkyle, à chaîne droite ou ramifié,
   $M^1$ étant choisi parmi Mg et Zn,
   $M^2$ étant choisi parmi Al et B,
   $M^3$ étant choisi parmi Si, Sn, Ti, Zr et Hf,
   la variable y étant choisie parmi zéro à 4.

4. Procédé selon l'une quelconque des revendications précédentes, l'oxyde de nickel-cobalt-manganèse stratifié lithié étant un matériau de formule générale (I)

$$Li_{(1+x)}[Ni_aCo_bMn_cM^4_d]_{(1-x)}O_2 \qquad (I)$$

   $M^4$ étant choisi parmi Mg, Ca, Ba, Al, Ti, Zr, Zn, Nb, Mo, V et Fe,
   zéro $\leq x \leq 0,2$,
   $0,1 \leq a \leq 0,8$,
   zéro $< b \leq 0,5$,
   $0,1 \leq c \leq 0,6$,
   zéro $\leq d \leq 0,1$
   et

$$a + b + c + d = 1.$$

5. Procédé selon l'une quelconque des revendications précédentes, les gaz d'échappement étant traités avec de l'eau à une pression au-dessus de la pression ambiante.

6. Procédé selon la revendication 5, les gaz d'échappement étant traités avec de l'eau à une pression dans la plage allant de 5 mbars à 1 bar au-dessus de la pression ambiante.

7. Procédé selon l'une quelconque des revendications précédentes, dans lequel dans l'étape (b) la pression est dans la plage allant de 5 à 350 mbars au-dessus de la pression ambiante.

8. Procédé selon l'une quelconque des revendications précédentes, les particules d'oxyde de nickel-cobalt aluminium lithié ou d'oxyde de nickel-cobalt-manganèse stratifié lithié, respectivement, étant cohésives.

9. Procédé selon l'une quelconque des revendications précédentes, l'étape (b) étant réalisée à une température dans la plage allant de 15 à 350 °C.

10. Procédé selon l'une quelconque des revendications précédentes, le réacteur dans lequel l'étape (b) est mise en œuvre étant purgé avec un gaz inerte entre les étapes (b) et (c).

11. Procédé selon l'une quelconque des revendications précédentes comprenant l'étape d'élimination du matériau revêtu du réacteur dans lequel les étapes (b) et (c) sont mises en œuvre par convection pneumatique.

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 8993051 B
- WO 2018019627 A

- US 2016260962 A